Europäisches Patentamt

European Patent Office

Office européen des brevets

(19)

(11) **EP 0 911 639 A1**

(12) **EUROPEAN PATENT APPLICATION**

(43) Date of publication:
28.04.1999 Bulletin 1999/17

(51) Int. Cl.⁶: $G01R\ 27/22$, $G01N\ 27/06$

(21) Application number: 97118220.9

(22) Date of filing: 21.10.1997

(84) Designated Contracting States:
AT BE CH DE DK ES FI FR GB GR IE IT LI LU MC
NL PT SE
Designated Extension States:
AL LT LV RO SI

(71) Applicant: WHIRLPOOL CORPORATION
Benton Harbor Michigan 49022 (US)

(72) Inventor: Turetta, Daniele
V.le G. Borghi 27, 21025 Comerio (IT)

(74) Representative:
Guerci, Alessandro
Whirlpool Europe S.r.l.
Patent Department
Viale G. Borghi 27
21025 Comerio (VA) (IT)

(54) **Method and device for compensating the signal drift in a conductivity cell used in a domestic appliance**

(57) The electrical AC supply of a conductivity cell used in a washing machine is at two different frequencies in order to compensate the signal drift due to scumming of the cell metal plates. The compensation function, in form of a formula or of a set of values stored in the electronic control circuit of the machine, is based on the ratio between the impedances at such different frequencies.

Fig. 2

EP 0 911 639 A1

**Description**

The present invention relates to a method for compensating the signal drift in a conductivity cell used in a domestic appliance. For domestic appliance it is meant any kind of appliance which makes use of tap water as washer, washer-dryer, dishwasher and water purifier.

It is well known in the field of domestic appliances the importance of collecting information on the conductivity of water fed to the washing machine or of the water solution present in the tub, particularly during rinsing. The use of conductivity cell allows theoretically to achieve suitable water and detergent utilization during the whole washing cycle of the machine. For example, devices are known which measure the water conductivity at the end of a wash or of a rinse stage in order to determine the water quantity to be used for the next stage in the treatment of the load in the machine. Moreover conductivity measurement is the most interesting method to be used in order to evaluate the quality of tap water, i.e. the hardness of the water, as disclosed in EP-A- 0 633 342, and for evaluating the rinsing performance, as disclosed in EP-A- 0 686 721.

However these known method and devices do not attain the object of properly dosing the detergent amount and limiting the water quantity used by the appliance during the treatment of the load based on the detergent quantity still present in the load, since the value measured by the conductivity cells are affected by a drift or deviation of the signal that, after some washing cycles, renders the conductivity measure totally unreliable and useless.

Water hardness is the main responsible for the formation of a film on the conductivity sensor. In addition to the deposition of calcium, magnesium and other elements ions, deposition on the surfaces of the conducting plates of zeolites, soil and everything used to perform the washing and rinsing process can affect the measure of the conductivity. To prevent completely the scumming of metal electrodes of a conductivity cell is not realistic. This can be reached in a laboratory, for instance by periodically cleaning or replacing the electrodes, but not in the normal working condition of a domestic appliance.

An object of the present invention is to provide a method which overcomes the drawbacks of known washing machines which make use of conductivity cells. A particular object of the invention is to provide a method which allow optimized detergent and water utilization in a washing machine irrespective of the number of washing cycles already performed by the machine.

A further object of the present invention is to provide a washing domestic appliance provided with conductivity cells whose measured values are not affected by signal drift, so that the reliability of the whole control arrangement is kept high and constant.

These and further objects which will be apparent to the expert of the art are attained by a method and by a washing domestic appliance in accordance with the accompanying claims.

According to the invention, the characteristic of the cell is evaluated, the quality of the cell is estimated and consequently any error due to deposition on the cell plates is compensated. A preferred method according to the invention is based on two different working frequencies keeping constant or knowing the amplitude of the signal. The two frequency are preferably comprised in the ranges 0.5 - 1.5 kHz and 5 - 15 kHz respectively, even if the frequency values are not critical.

According to a preferred embodiment of the invention, the conductivity cell is supplied with alternate current at a first and second frequency respectively, a function based on the signal values measured at said different frequencies being indicative of the signal drift of the cell and being used to compensate it. A sinusoidal alternate current is preferred, but also an alternate current based on square or triangular wave may be used as well. The above function is preferably based on the ratio between the signal values measured at different frequencies, and more preferably it is a logarithmic function of the type:

$$C = \text{Log}_{10} \text{ s1/R} * 100$$

where: C is the compensated value, s1 is the value of the signal measured at a first frequency and R= s2/s1 , s2 being the value of the signal measured at a second frequency lower than the first.

In a different embodiment of the invention, instead of using two or more fixed frequencies, the conductivity cell may be supplied with a variable frequency and, on the basis of the function or table of values which correlates the impedance of the cell and the frequency value of the current, a compensation of the measured signal can be made. In other words, the conductivity cell may be subjected to a frequency scanning and, on the basis of the scanning result, the compensation is carried out.

The method and a washing appliance in which the method according to the invention is carried out will be more apparent from the accompanying drawings, which are provided by way of non-limiting example and in which:

-    Figure 1 represents the equivalent circuit of a conductivity cell,
-    Figure 2 is a schematic representation of a washing machine provided with two conductivity cells in which life tests for determining the compensation value of each cell were carried out,

- Figure 3 is a schematic representation of a first embodiment of electrical connection of a conductivity cell according to the invention,
- Figure 4 is a diagram showing the impedance values of a first conductivity cell of the washing machine of figure 2 with working frequencies of 1kHz and 10 kHz vs. the number of washing cycles,

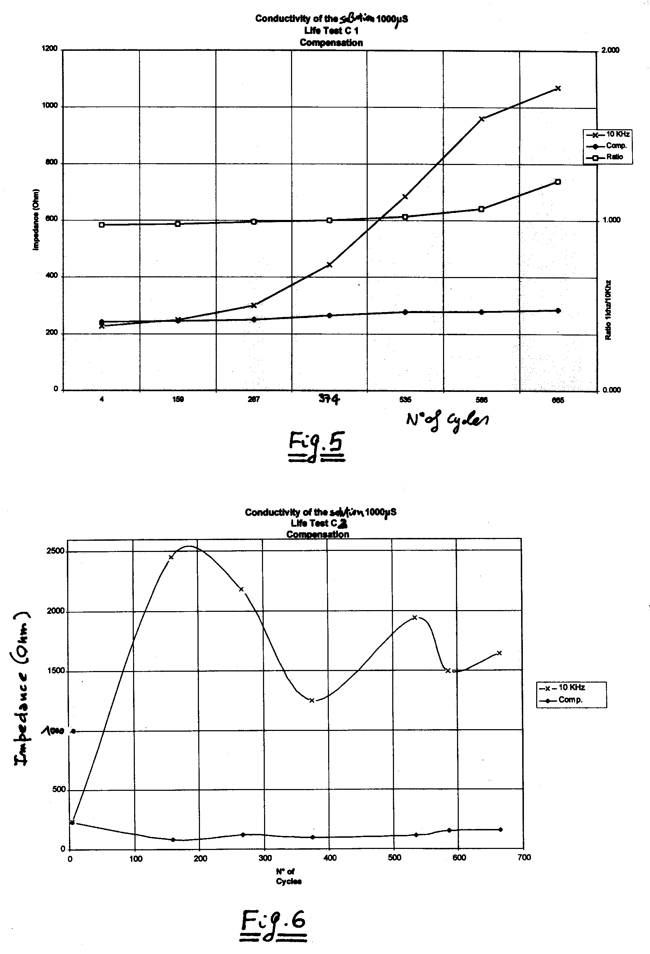

- Figure 5 is another diagram showing the impedance value of the same cell with a working frequency of 10 kHz (axes Y1), the ratio between the impedance value measured for a working frequency of 1 kHz and 10 kHz respectively (axes Y2) and the compensated value of impedance (axes Y1) obtained by using the method according to the invention,
- Figure 6 is a diagram similar to Figure 5 (in which the above ratio is not represented) for a second conductivity cell of the washing machine of figure 2,
- Figure 7 is a schematic representation of a second embodiment of electrical connection of a conductivity cell according to the invention, and
- Figures 8-10 show three embodiments of schematic electronic circuits of a washing machine according to the invention.

In order to understand the signal analysis of a conductivity cell it is useful to consider in detail the general criteria that govern the cell for measurement of electrolyte solution conductance.

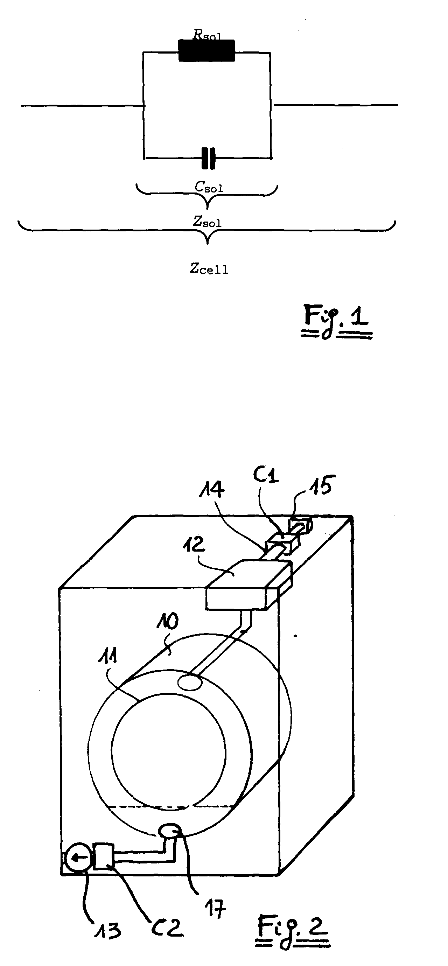

From theoretical point of view the equivalent circuit of a conductivity cell is represented in Figure 1, where $R_{sol}$ represents the resistance of the solution contained in the cell, $C_{sol}$ represents the electrolyte capacitance, $Z_{sol}$ the impedance of the solution and $Z_{cell}$ the impedance of the conductivity cell.

Hence, in dependence of the characteristics of the chosen circuit the following approximations may be generally applied:

$Z_{cell} \approx Z_{sol}$ and $Z_{sol}$ is split into the two contributions $R_{sol}$ and $C_{sol}$.

In addition, it is worth noting that in order to avoid electrolytic phenomena a conductivity cell must be biased by a AC signal.

In the known washing machines an undesirable condition occurs when the presence of deposition changes the values of the resistor $R_{sol}$ and capacitor $C_{sol}$ even if the solution maintains the same conductivity value.

The final impedance value can be approximately calculated by the electrical parallel *Rx // Xc* through the formula

$$Z_{cell} = \frac{Xc^{*}Rx}{Xc+Rx}$$

where the $R_{sol} = Rx$ and $C_{sol} = Xc$ when the capacitive reactance is obtained by

$$Xc = \frac{1}{2^{*}\pi^{*}f^{*}C}$$

where f is the frequency of the AC current supplied to the cell and C is the capacitance value measured through a RLC meter.

Life test made with two cells positioned according to Figure 2 has demonstrated that the impedance variation is proportional to the quality of the cell where such quality means the amount of deposition of calcium, zeolites, etc. on the surface of the conducting plates.

With reference to Figure 2, the washing machine used in the above test comprises a tub 10, a drum 11 rotating within the tub 10, a detergent dispenser 12 and a pump 13 for discharging the solution contained in the tub. On a fresh water inlet pipe 14, downstream an on/off solenoid valve 15, a first conductivity cell C1 is placed. A second conductivity cell C2 is placed within a discharge pipe downstream a flap valve 17 and upstream the discharge pump 13.

For all the series of tests a washing machine model Bauknecht WA 3773, modified according to Figure 2, was used.

Accelerated life test have been performed with artificial hardness, artificial soil, commercial detergent in powder form. Tap water has been added with soluble salts ($CaCl_2$ and $NaHCO_3$) in order to prepare and store a batch solution having a hardness of 40° dH under a controlled nitrogen atmosphere. Measurements on each cell have been carried out by keeping constant the conductivity value of the solution under analysis (1000 μS) and each cell was biased alternatively by an AC signal with constant amplitude but different working frequency. The constant of the cell (K value) used in the test was 4.

Example 1

In a life test the impedance value of the cell C1 has been measured after different numbers of complete washing cycles in order to simulate the life of the cell. C1 was affected only by water hardness and not by soil and detergent. The washing cycle was a normal 60°C cycle with one rinse for a total time of 60'. Every 9 cycles at 60°C, a 90°C cycle was carried out in order to better simulate the real "life" of a washing machine.

The following is a test method to be used in order to perform in the laboratory the measures of the impedance and in particular the variation of impedance.

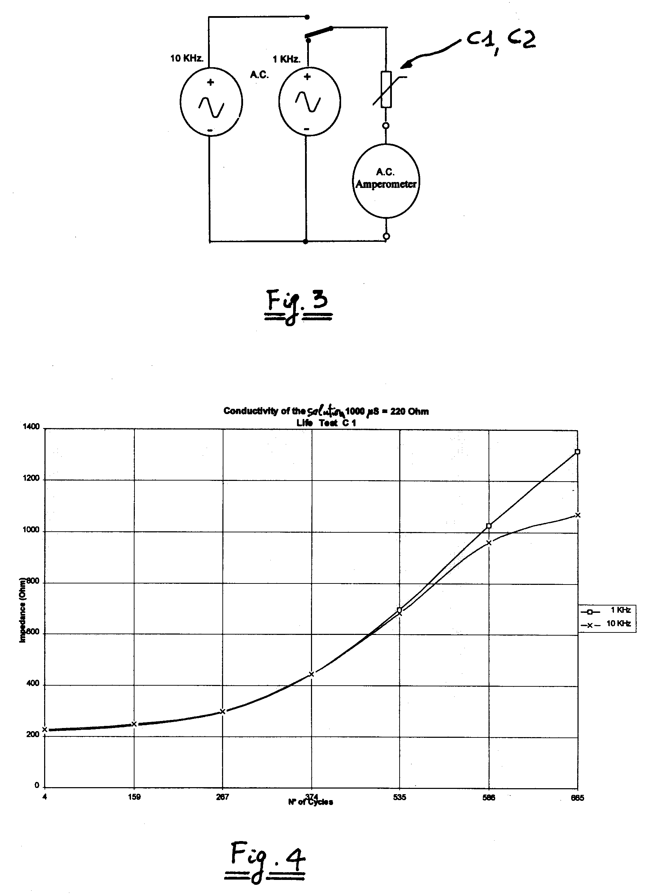

According to Figure 3, cell C1 was biased by two sinewave generator of 1 kHz and 10 kHz respectively with a constant amplitude signal (0,5 V p.p.), and was connected in series mode with an AC ammeter. The current measured by the instrument was correlated with the impedance of the cell. Ratio between current measured with the two frequencies was correlated to the quality of the cell.

Since the conductivity value of the solution used during the conductivity measures was constant, it is immediately apparent from the following table 1 the effect of the drift or deviation of the impedance signal due to the "aging" of the cell C1.

Table 1

|  | 1KHz | 10 KHz |  |
|---|---|---|---|
| Cycles | Ohm | Ohm | Ratio |
| 4 | 221 | 228 | 0.969 |
| 159 | 244 | 250 | 0.976 |
| 267 | 297 | 300 | 0.990 |
| 374 | 445 | 443 | 1.005 |
| 535 | 698 | 684 | 1.020 |
| 586 | 1026 | 960 | 1.069 |
| 665 | 1319 | 1070 | 1.232 |

The ratio in the above table is the ratio of the impedance values in Ohm measured at 1kHz and 10 kHz respectively.

The applicant has surprisingly observed that the ratio between the impedance values measured at different working frequencies is a quality indicator of the cell and consequently it is possible to compensate this drift or deviation.

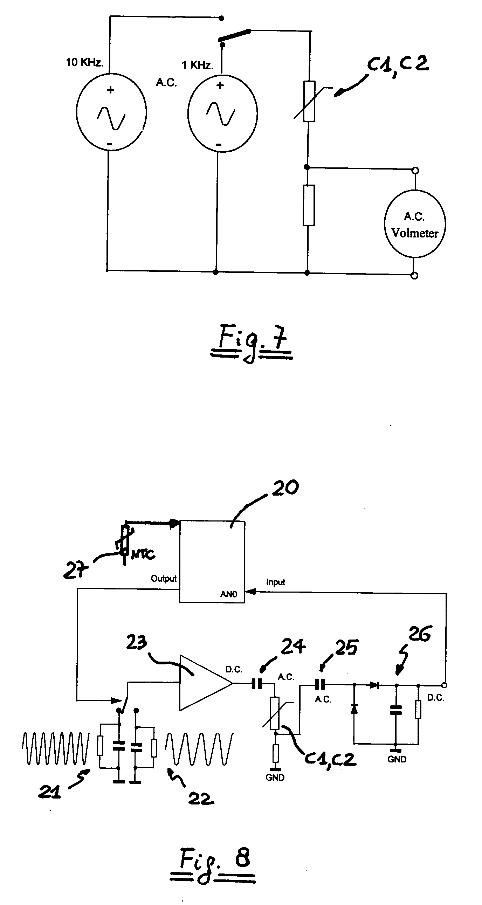

Figure 8 shows the impedance values for the cell C1 with working frequency of 1 kHz and 10 kHz vs. number of cycles.

A good rule for compensating the impedance measured value by taking into account the ratio of the impedance values at two different frequencies is a logarithmic function as follows:

$$\text{Compensated value} = \text{Log}_{10}(\text{Impedance at 10 kHz})/\text{Ratio}*100$$

where Ratio is the ratio between measured impedance values at 1kHz and 10 kHz.

The following table (Table 2) shows the compensated values after the same numbers of cycles of previous table 1.

Table 2

|  | 10 kHz |  |  |
|---|---|---|---|
| Cycles | Ohm | Ratio | Compensated values (Ohm) |
| 4 | 228 | 0.969 | 243 |
| 159 | 250 | 0.976 | 245 |

Table 2 (continued)

| Cycles | 10 kHz Ohm | Ratio | Compensated values (Ohm) |
|---|---|---|---|
| 267 | 300 | 0.990 | 250 |
| 374 | 443 | 1.005 | 264 |
| 535 | 684 | 1.020 | 278 |
| 586 | 960 | 1.069 | 279 |
| 665 | 1070 | 1.232 | 285 |

Figure 3 shows the impedance value of the cell C1 with a working frequency of 10 kHz (axes Y1), the ratio between the impedance value measured for a working frequency of 1kHz and 10 kHz (axes Y2) and the compensation (axes Y1) obtained by the use of the above formula.

Example 2

During the same life test described in Example 1 the compensation of cell C2 was investigated. The same formula was used for cell C2 placed upstream the discharge pump where the contamination was affected by water hardness, artificial soil (clay + oil) and detergent. The result of life test for cell C2 is shown in Figure 8; according to the results, the same method and formula thereof may be used successfully also for conductivity cells used in the more severe environment of the tub (where soil and detergent concentration are responsible for an increase of the signal drift). On the other hand it is well known that, in order to exploit all the advantages of conductivity cells in a washing machine, it is important to monitor not only the hardness of the incoming water, but also the concentration of the detergent for instance in the rinsing stage of the washing cycle.
It is obviously not necessary to use a microprocessor able to apply the above logarithmic formula; a table of values stored in a microprocessor may be used as well.
From the results of life test it appears that, when the ratio between impedances at two different frequencies is about or lower than 0.99, this means that the conductivity cell has not been affected yet by a relevant signal drift.
Another method to perform in a laboratory the measures of impedance and in particular the variation of impedance is shown in figure 7. The conductivity cell is connected in series with a constant resistor R in order to form a voltage divider.
This resistor has in parallel an AC voltmeter. The voltage measured by the instrument is correlated with the impedance of the cell. Ratio between current measured with the two frequency is correlated to the quality of the cell.
The method for the compensation of conductivity values may be implemented in washing machines with only a little and inexpensive modification of the usual electronic controlling circuit of the machine.
In figure 8 is shown a first embodiment of a schematic electronic circuit of a washing machine which is capable of evaluating the impedance of the solution and, at the same time, the quality of the cell and consequently is able to compensate the error. In the electronic circuit of Figure 8, for sake of clarity, there are shown only the components which are related to the measurement of the conductivity. Reference 20 indicates a control unit, 21 and 22 two fixed frequency generators, 23 a sinewave generator, 24 and 25 two coupling capacitors and 26 an integrator circuit. The control unit 20 is linked to a NTC sensor 27 for a known temperature compensation of the conductivity value.

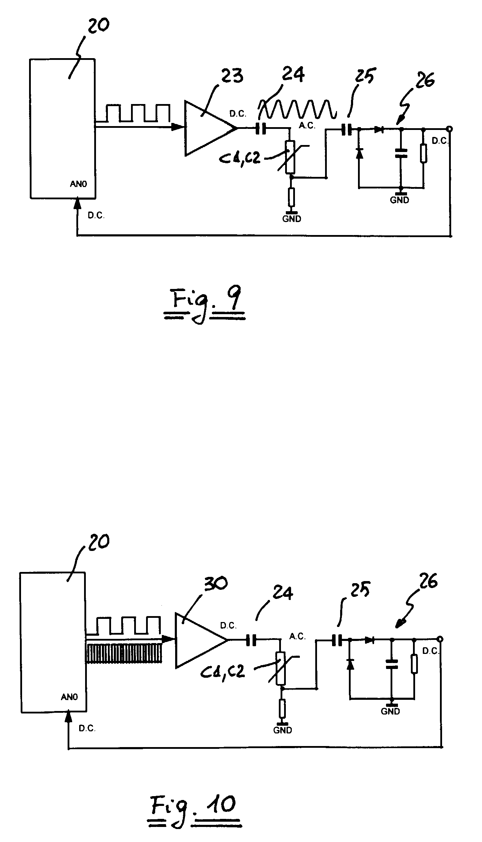

In Figure 9 a second embodiment of an electronic circuit of a washing machine according to the invention is shown, where similar components are indicated with the same reference numbers. In this embodiment the control unit 20 comprises a microprocessor for generating a digital PWM signal to be fed to the sinewave generator 23.
Figure 10 shows a third embodiment of an electronic circuit to be used in a domestic appliance according to the invention, such circuit being quite similar to the circuit shown in Figure 9. In this embodiment the sinewave generator is replaced with a buffer circuit 30 supplied with square waves at different frequencies.

Claims

1.    Method for compensating the signal drift in a conductivity cell used in a domestic appliance, characterized in that the conductivity cell is supplied with alternate current at more than one frequency, a function based on the signal values measured at said different frequencies being indicative of the signal drift of the cell and being used to compensate it.

2. Method according to claim 1, characterized in that said function is based on the ratio between the signal values measured at two different frequencies.

3. Method according to claim 2, characterized in that said function is a logarithmic function.

4. Method according to claim 3, characterized in that the function is:

$$C = \text{Log}_{10} \ s1/R * 100$$

where:

C is the compensated value,
s1 is the value of the signal measured at a first frequency,
R is the ratio s2/s1, s2 being the value of the signal measured at a second frequency lower than the first.

5. Washing domestic appliance, of the type comprising at least a conductivity cell which is connected to a control unit for providing this latter with a signal indicative of the electrical conductivity of the liquid fed and/or contained within the appliance, characterized in that the control unit comprises means for supplying the cell with alternate current at more than one frequency, means for measuring the signals corresponding to said different frequencies and means for calculating or applying a compensated value based on a function of said signals, said compensated value being substantially not affected by drift of the signal of the conductivity cell.

6. Washing domestic appliance according to claim 5, characterized in that said means for calculating the compensated value are based on a function of the ratio between the values of the signal at two different frequencies.

7. Washing domestic appliance according to claim 6, characterized in that said function is a logarithmic function.

8. Washing domestic appliance according to claim 7, characterized in that the function is:

$$C = \text{Log}_{10} \ s1/R * 100$$

where:

C is the compensated value,
s1 is the value of the signal measured at a first frequency,
R is the ratio s2/s1, s2 being the value of the signal measured at a second frequency lower than the first.

$R_{sol}$

$C_{sol}$

$Z_{sol}$

$Z_{cell}$

Fig. 1

C1

14    15

12

10

11

13    C2    17

Fig. 2

**Fig. 3**

**Fig. 4**

**Fig.5**

**Fig.6**

**Fig. 7**

**Fig. 8**

Fig. 9

Fig. 10

11

**European Patent Office**

## EUROPEAN SEARCH REPORT

Application Number

EP 97 11 8220

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US 5 504 430 A (ANDERSSON LARS)<br>* column 4, line 44 - column 5, line 9 *<br>--- | 1,2 | G01R27/22<br>G01N27/06 |
| A | DD 218 468 A (HUMBOLDT-UNIVERSITÄT ZU BERLIN)<br>* the whole document *<br>----- | 1,5 | |

| | | | TECHNICAL FIELDS SEARCHED (Int.Cl.6) |
|---|---|---|---|
| | | | G01R<br>G01N |

The present search report has been drawn up for all claims

| Place of search | Date of completion of the search | Examiner |
|---|---|---|
| THE HAGUE | 9 March 1998 | Six, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03 82 (P04C01)

## ANNEX TO THE EUROPEAN SEARCH REPORT
## ON EUROPEAN PATENT APPLICATION NO.

EP 97 11 8220

This annex lists the patent family members relating to the patent documents cited in the above-mentioned European search report.
The members are as contained in the European Patent Office EDP file on
The European Patent Office is in no way liable for these particulars which are merely given for the purpose of information.

09-03-1998

| Patent document cited in search report | Publication date | Patent family member(s) | Publication date |
|---|---|---|---|
| US 5504430 A | 02-04-96 | NONE | |
| DD 218468 A | | NONE | |

EPO FORM P0459

For more details about this annex : see Official Journal of the European Patent Office, No. 12/82